# EUROPEAN PATENT APPLICATION

(11) **EP 0 532 015 A2**
(43) Date of publication of application: **17.03.1993**
(21) Application number: 92115536.2
(22) Date of filing: 10.09.1992
(51) Int. Cl.: H01L 21/60, H01L 23/488, H01L 21/603

(54) **Method of establishing soldered connections**

(30) Priority: 13.09.1991 US 759246
(71) Applicant: GTE LABORATORIES INCORPORATED, Wilmington Delaware 01901 (US)
(72) Inventor: Fitzgerald, Thomas W., Framingham, MA 01701 (US); Chirravuri, Jagannath, Medfield, MA 02052 (US); Tabasky, Marvin, Peabody, MA 01960 (US); Barry, Vincent J., Framingham, MA 01701 (US); Cataldo, Victor J., Wilmington, MA 01887 (US)
(74) Representative: Grünecker, Kinkeldey, Stockmair & Schwanhäusser Anwaltssozietät

(57) **Abstract**

A method of connecting a component (21) with regions of selective metallization to a reference surface (25) comprises the steps of forming a desired pattern of wettable metal pads (10,11,12) on the reference surface (25), depositing solder (13) on each of the pads (10,11,12), and rigidly positioning the component (21) on the reference surface (25). When the solder (13) is heated, each of the solder patterns (27) reflows and contacts a respective region of metallization on the component (21) without movement of either the component (21) or the reference surface (25).

## Description

This invention relates to establishing electrical connections and, more particularly, to a method of soldering components to reference surfaces of integrated device structures.

The efficient transfer of light between generating (lasers) and receiving (detectors) components and transmitting elements (fibers and waveguides) requires that the components be arranged and secured in precise positions during manufacture.

Conventional techniques for maintaining such positional integrity utilize soft solder alloys to establish electrical connections between components wherein the solder is preplaced in desired contact areas prior to heating. During soldering, the relative positions of the components are maintained by either temporary mechanical connection, such as crimping or hole pins, or by specially-designed jigs and fixtures.

Disadvantageously, there is movement among the components while heat is applied to the assembly since the solder melts and temporarily loses its rigidity. This allows other components that may have been supported or positioned by the solder to shift slightly. Although these shifts may be small, the relative movements of the components may be sufficient to cause the components to be fixed in misalignment, thereby adversely affecting performance in electro-optical assemblies where highly precise alignments are critical.

M.J. Wale in "Self Aligned, Flip Chip Assembly of Photonic Devices with Electrical and Optical Connections", discusses an alignment technique representative of the prior art directed to the use of a solder reflow phenomenon to bond components together. In the optical assembly of Wale, a waveguide chip is soldered to a substrate having a V-groove so that a fiber positioned in the groove is aligned with the waveguide. Wale initially forms an array of wettable metal pads on the surface of both the chip and substrate, and then forms an array of solder pads overlaying the wettable metal pads. The solder and metal pads are placed in contact and the solder is reflowed, thereby causing surface tension forces to move the substrate and chip into alignment. Subsequent cooling of the assembly fixes the components in this aligned position.

As indicated in Figure 7(e) of Wale, the volume of solder and the relative size of the wettable pad surfaces affect the optical alignment between the fiber and the waveguide. Consequently, precise dimensional control of the pads and solder are necessary in Wale if the fiber positioned in the V-groove is to be optically aligned to the waveguide in the bonded assembly.

In accordance with the present invention, there is provided a method of connecting a component with regions of selective metallization to a reference surface, comprising the steps of: forming a desired pattern of solder-wettable metal pads on said reference surface; depositing solder on each of said pads; integrating said component with said surface in a fixed, rigid position; and sufficiently heating said solder to reflow and contact respective regions of selective metallization to form electrical connections with said pads.

In the drawings:
Figure 1 illustrates the reflow phenomenon utilized in the present invention; and
Figure 2 shows an optoelectronic device for illustrating the principles of the present invention.

The present invention is concerned with soldering the contact surface of an optoelectronic component to a reference surface of a device assembly for establishing an electrical connection therebetween. In accordance with the present invention, suitable wettable metal pads are placed on the reference surface in predetermined areas and a solder pattern is deposited on each of the pads. The contact surface of the component is selectively metallized with contact pads each associated with a corresponding metal pad on the reference surface.

The component is then integrated into the assembly relative to the reference surface such that the component is optically aligned with other structures in the assembly. Although integrated, the deposited solder patterns and the contact pads are physically separated. The aforementioned optical alignment may occur, for example, between a light-generating or light-receiving component such as a laser or detector, respectively, and a light-transmitting element integrated with the reference surface. The light-transmitting element may be a fiber or waveguide, while the reference surface may be the upper surface of a substrate body.

Subsequent heating of the solder causes the solder to sufficiently reflow ("mound up") due to surface tension whereby the meniscus of each solder pattern contacts its associated pad on the contact surface of the component, and rises to distribute itself over the surface of the pad. Consequently, a connection is formed between the reference surface and the component without an initial physical connection therebetween. A particular advantage of the present invention is that the component is rigidly integrated with the reference surface so that neither the component nor the surface experiences movement during formation of the solder connection.

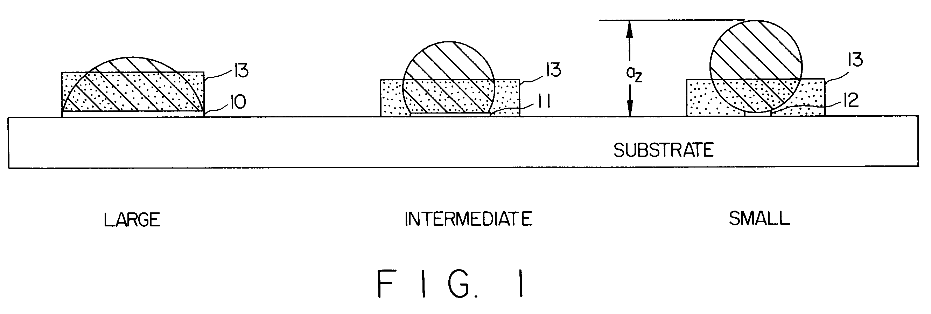

Figure 1 shows three wettable metal pads 10, 11, and 12 varying in surface area for illustrating the reflow phenomenon. An equal volume of solder 13 is deposited on each pad, with the cross-hatched volume of solder representing a cross-section of the reflowing solder. As indicated, a pad with smaller dimensions causes greater mounding or vertical elevation of the reflowed solder to a height such as **a**_{**z**} in the smallest pad 12. This mounding principle, defined as the tendency for solder deposited on a partially non-wetting surface to mound or "ball-up" on melting, is used in the present invention as discussed below.

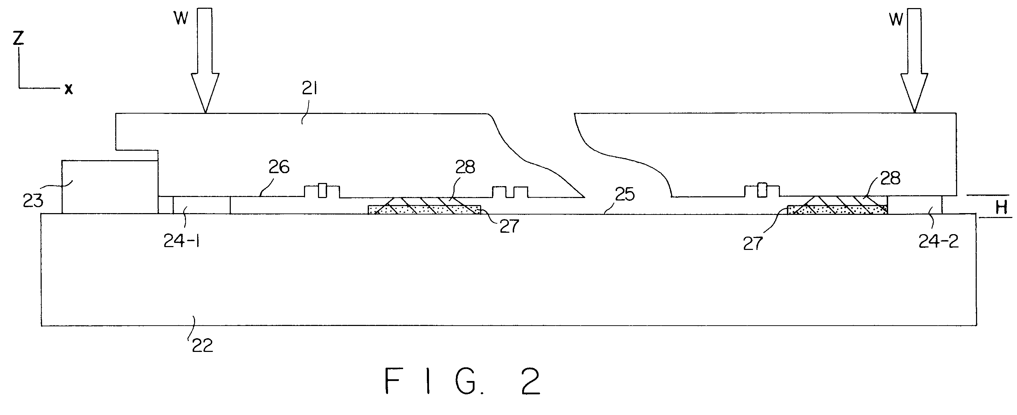

Figure 2 shows a cross-sectional view of the optical assembly disclosed in the aforementioned copending application. As shown, the assembly includes a laser array chip 21 positioned in the x and y-directions on a substrate 22 by placing the chip 21 in concurrent abutting contact with one side pedestal 23 and two front pedestals (not shown). Standoff structures 24-1 and 24-2 support the chip and facilitate alignment in the z-direction. The method of the present invention is utilized to solder the chip 21 to the substrate surface 25.

In accordance with the present invention, wettable metal pads are placed on the substrate surface 25 and solder patterns 27 are then deposited on each of the pads. The contact surface 26 of the chip is selectively metallized in predetermined areas to form metal pads each associated with a corresponding pad on the substrate. The chip is integrated with the substrate surface 25 using the pedestal structures and the z-axis standoffs disclosed in the copending application. The height of each deposited solder pattern is less than the height **h**_{**z**} of the z-axis standoffs 24-1 and 24-2 defining the spacing between the laser array surface 26 and the reference plane of surface 25.

On heating, each prepositioned solder pattern melts, "mounds" up as the cross-hatched solder mound 28, and touches the corresponding metal pad on the laser surface 26 providing that **a**_{***z***}**≧h**_{**z**}. Unlike Wale, supra, the solder connection of the present invention is established without movement of either the array or the substrate. In particular, the side and front pedestal structures in Figure 2 rigidly position the chip 21 relative to the substrate surface 25 so that both the chip and the substrate remain motionless during the formation of the solder connection.

Because the solder wets the laser array, the joint remains undisturbed as the assembly cools and the solder solidifies. Other components may be located relative to the surface 25 and are thereby referenced to each other. It should be obvious to those skilled in the art that the geometry of the component metallization, wettable metal pads, and the deposited solder may be varied considerably. However, the dimensions must be appropriately chosen such that each of the solder patterns sufficiently reflows to contact the associated pads on the component.

A wafer assembly was constructed in accordance with Figure 2 to illustrate that the melting solder mounds up due to surface tension and makes contact with the laser array positioned above but not in contact with the prepositioned solder patterns on the silicon substrate surface. The substrate had an average groove width of 140µ with the fiber core being located 8.69µ above the substrate surface, and the z-standoffs were 5.24µ high. The deposited indium solder patterns were each 4.00µ high, requiring that the solder upon melting had to mound-up at least 1.24µ. Tests conducted with the lasers showed that an electrical contact had been established.

Although the principles of the present invention are illustrated with the assembly of Figure 2, this should not serve as a limitation of the present invention. Rather, it should be obvious to those skilled in the art that the present invention is applicable to other such assemblies capable of rigidly integrating electro-optic components with reference surfaces using fixed reference marks or features prior to establishing soldered electrical contacts. Preferably, the components will be in optical communication with other devices when rigidly integrated with the reference surface. Furthermore, the solder is not limited to AuSn but includes all other suitable solders well known to those skilled in the art.

While there has been shown and described what are at present considered the preferred embodiments of the invention, it will be obvious to those skilled in the art that various changes and modifications can be made therein without departing from the scope of the invention as defined by the appended claims.

## Claims

1. A method of connecting a component with regions of selective metallization to a reference surface, comprising the steps of:
forming a desired pattern of solder-wettable metal pads on said reference surface;
depositing solder on each of said pads;
integrating said component with said surface in a fixed, rigid position; and
sufficiently heating said solder to reflow and contact respective regions of selective metallization to form electrical connections with said pads.

2. The method as recited in claim 1 wherein the formation of said electrical connections occurs without movement of either said component or said reference surface.

3. The method as recited in claim 2 wherein said component includes a plurality of active regions; and
said reference surface is integrated with an optoelectronic device having a plurality of optical receiving elements.

4. The method as recited in claim 3 wherein the active regions of said rigidly positioned component are in optical communication with receiving elements of said optoelectronic device.

5. The method as recited in claim 4 wherein the step of rigidly positioning said component on said surface includes the step of:
abutting a front face of said component with contact surfaces of two front pedestals formed at respective locations on said reference surface; and
abutting a sidewall of a mating channel formed in a lateral area of said component to a contact surface of a side pedestal formed at a respective location on said reference surface.

6. A method of connecting a component with regions of selective metallization to a reference surface having a pattern of wettable metal pads each associated with a corresponding region of selective metallization, comprising the steps of:
depositing solder on each of said pads;
integrating said component with said surface in a fixed, rigid position; and
sufficiently heating said solder to reflow and contact corresponding regions of selective metallization to form electrical connections with said pads.

7. The method as recited in claim 7 wherein the formation of said electrical connections occurs without movement of either said component or said reference surface.
